# EUROPEAN PATENT APPLICATION

(11) **EP 4 053 898 A1**
(43) Date of publication of application: **07.09.2022**
(21) Application number: 22160170.1
(22) Date of filing: 04.03.2022
(51) Int. Cl.: H01L 25/075, H01L 25/16, H01L 33/00, H01L 33/50, H01L 33/58, H01L 33/60

(54) **MICRO LED PANEL AND METHOD FOR MANUFACTURING THE SAME**

(30) Priority: 05.03.2021 KR 20210029712
(71) Applicant: Lumens Co., Ltd., Yongin-si, Gyeonggi-do 16976 (KR)
(72) Inventor: OH, Seung Hyun, 16976 Gyeonggi-do (KR); KIM, Pyeong Guk, 16976 Gyeonggi-do (KR); PARK, Jung Hyun, 16976 Gyeonggi-do (KR)
(74) Representative: Hoffmann Eitle

(57) **Abstract**

Provided is a method of manufacturing a micro LED panel, the method including preparing a backplane; forming a plurality of micro LED cells in a matrix shape on a bottom portion of a growth substrate; bonding the micro LED cells to the backplane; separating the growth substrate from the micro LED cells; and disposing a partitioning wall structure on top portions of the micro LED cells, wherein the partitioning wall structure includes a light-transmitting member having a first surface facing light-emitting surfaces of the micro LED cells and a second surface facing the first surface, the light-transmitting member includes a plurality of first grooves formed to correspond in between the plurality of micro LED cells on any one of the first surface and the second surface, and the plurality of first grooves are filled with a partitioning wall composition to form partitioning walls.

## Description

### CROSS-REFERENCE TO RELATED APPLICATION

This application is based on and claims priority under 35 U.S.C. §119 to Korean Patent Application No. 10-2021-0029712, filed on March 5th, 2021, in the Korean Intellectual Property Office, the disclosure of which is incorporated by reference herein in its entirety.

### BACKGROUND

### 1. Field

The disclosure relates to a micro LED panel and a method of manufacturing the micro LED panel, and more particularly, to a micro LED panel including a plurality of micro LED cells arranged in a matrix shape and partitioning walls capable of minimizing crosstalk between the micro LED cells and a method of manufacturing the micro LED panel.

### 2. Description of the Related Art

In recent years, many researches and developments are being conducted on display technology to which mini-LED or micro-LED is applied. Conventional display technology using mini LED or micro LED generally implements individual pixels by using individual R/G/B chips (micro LED chips or mini LED chips) or by using mini LED chips or micro LED chips and a phosphor sheet or a quantum-dot sheet disposed thereon.

However, the method of implementing individual pixels by using individual R/G/B chips is expensive. Meanwhile, the method of applying a phosphor sheet or a quantum-dot sheet onto micro LED chips or mini LED chips is a method in which one phosphor sheet or quantum-dot sheet performs wavelength conversion on light emitted from micro LED chips, which neighbor one another at a fine interval, at once. When pixels are miniaturized to 100 µm or smaller, severe light spreading occurs due to crosstalk between cells, and thus there is a limit in implementing a high resolution.

Also, in recent years, there have been attempts to apply micro LED display technology to automobile headlights. However, when the existing technology is applied as it is, in addition to the above-stated problems like light spreading and resolution degradation, various problems may occur due to limitations in heat dissipation performance.

### SUMMARY

The disclosure provides a micro LED panel configured to perform individual wavelength conversion of light from micro LED cells by using a partitioning wall structure having formed therein partitioning walls and a method of manufacturing the micro LED panel.

Additional aspects will be set forth in part in the description which follows and, in part, will be apparent from the description, or may be learned by practice of the presented embodiments of the disclosure.

According to an embodiment of the disclosure, a method of manufacturing a micro LED panel, the method includes preparing a backplane; forming a plurality of micro LED cells in a matrix shape on a bottom portion of a growth substrate; bonding the micro LED cells to the backplane; separating the growth substrate from the micro LED cells; and disposing a partitioning wall structure on top portions of the micro LED cells, wherein the partitioning wall structure includes a light-transmitting member having a first surface facing light-emitting surfaces of the micro LED cells and a second surface facing the first surface, the light-transmitting member includes a plurality of first grooves formed to correspond in between the plurality of micro LED cells on any one of the first surface and the second surface, and the plurality of first grooves are filled with a partitioning wall composition to form partitioning walls.

According to an embodiment of the disclosure, the partitioning wall structure may be formed through a process including preparing the light-transmitting member; forming the plurality of first grooves by cutting to a pre-set depth from the first surface or the second surface of the light-transmitting member by using a contact or non-contact cutting device; and forming partitioning walls by filling the plurality of first grooves with a partitioning wall composition.

According to an embodiment of the disclosure, the light-transmitting member may include a phosphor for individual wavelength conversion of light from each of the micro LED cells.

According to an embodiment of the disclosure, the light-transmitting member may further include a plurality of second grooves formed on the other one of the first surface and the second surface to face the plurality of first grooves.

According to an embodiment of the disclosure, the plurality of first grooves may include concave-convex surfaces.

According to an embodiment of the disclosure, the forming of the plurality of micro LED cells in a matrix shape at the bottom of the growth substrate may include sequentially stacking a first conductivity type semiconductor layer, an active layer, and a second conductivity type semiconductor layer on the growth substrate; separating active layers of the micro LED cells by removing portions of the second conductivity type semiconductor layer and the active layer; and separating the micro LED cells by removing the first conductivity type semiconductor layer between the micro LED cells.

According to an embodiment of the disclosure, the method may further include, after the bonding of the micro LED cells to the backplane and before the separating of the growth substrate from the micro LED cells, filling and curing an adhesive material between the micro LED cells.

According to an embodiment of the disclosure, a micro LED panel includes a backplane on which a plurality of individually driven LED driving circuits are arranged in a matrix shape; a plurality of micro LED cells formed to respectively correspond to the plurality of LED driving circuits and each having a pair of first conductivity type electrode pad and a second conductivity type electrode pad formed therebelow; a partitioning wall structure located above the light-emitting surfaces of the micro LED cells and having a plurality of first grooves formed therein; and an adhesive member formed between a top portion of the light-emitting surfaces and a bottom portion of the partitioning wall structure, wherein the plurality of first grooves are formed at locations corresponding to in between the micro LED cells, and, in the partitioning wall structure, partitioning walls are formed by filling the plurality of first grooves with a composition.

According to an embodiment of the disclosure, the partitioning wall structure may include a light-transmitting member having a first surface facing the light-emitting surfaces and a second surface facing the first surface, and the plurality of first grooves may be formed on any one of the first surface and the second surface of the light-transmitting member.

According to an embodiment of the disclosure, the light-transmitting member may include a phosphor for individual wavelength conversion of light from each of the micro LED cells.

According to an embodiment of the disclosure, the adhesive member may include a phosphor for individual wavelength conversion of light from each of the micro LED cells.

According to an embodiment of the disclosure, the light-transmitting member may further include a plurality of second grooves formed on the other one of the first surface and the second surface to face the plurality of first grooves.

According to an embodiment of the disclosure, the plurality of first groove and the plurality of second groove facing each other may not contact each other.

According to an embodiment of the disclosure, the plurality of first grooves may be formed by cutting to a pre-set depth from the first surface or the second surface of the light-transmitting member by using a contact or non-contact cutting device.

According to an embodiment of the disclosure, a first depth of the plurality of first grooves may be less than 1/2 times a thickness of the light-transmitting member.

According to an embodiment of the disclosure, the first depth of the plurality of first grooves may have a value between 1/2 and 1 times the thickness of the light-transmitting member.

According to an embodiment of the disclosure, the composition may include an organic or inorganic resin material.

According to an embodiment of the disclosure, the plurality of first grooves may include concave-convex surfaces.

According to an embodiment of the disclosure, a width of the plurality of first grooves may become narrower in a depth-wise direction away from the first surface or the second surface on which the first grooves are formed.

According to an embodiment of the disclosure, the partitioning wall structure may further include a substrate member disposed on the second surface of the light-transmitting member.

Other aspects, features, and advantages will become apparent from the following drawings, claims, and detailed description of the disclosure.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a cross-sectional view of a micro LED panel according to an embodiment of the disclosure;
FIG. 2 is an enlarged cross-sectional view of a portion of FIG. 1;
FIG. 3 is a perspective view of a partitioning wall structure applicable to the micro LED panel shown in FIG. 1;
FIGS. 4 and 5 are diagrams for describing a method of manufacturing the partitioning wall structure stated above;
FIGS. 6 to 11 are diagrams showing examples of a partitioning wall structure according to various embodiments of the disclosure;
FIGS. 12 to 14 are diagrams for describing a method of manufacturing a micro LED panel according to an embodiment of the disclosure; and
FIG. 15 is a diagram showing images of micro LED panels manufactured according to the present embodiment and a comparative example compared for each process.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

Reference will now be made in detail to embodiments, examples of which are illustrated in the accompanying drawings. In the drawings, the same elements are denoted by the same reference numerals, and a repeated explanation thereof will not be given.

Since various modifications may be made in embodiments of the disclosure, particular embodiments will be illustrated in the drawings and detailed descriptions thereof will be given below. The effects and features of the embodiments and the accompanying methods thereof will become apparent from the following description of the embodiments, taken in conjunction with the accompanying drawings. However, the embodiments are not limited to the embodiments described below, and may be embodied in various modes.

It will be understood that although the terms "first", "second", etc. may be used herein to describe various elements, these elements should not be limited by these terms. These elements are only used to distinguish one element from another.

As used herein, the singular forms "a," "an" and "the" are intended to include the plural forms as well, unless the context clearly indicates otherwise.

It will be further understood that the terms "comprises" and/or "comprising" used herein specify the presence of stated features or components, but do not preclude the presence or addition of one or more other features or components.

It will be understood that when a unit, region, or component is referred to as being "formed on" another layer, region, or component, it can be directly or indirectly formed on the other unit, region, or component. That is, for example, intervening units, regions, or components may be present.

In the embodiments below, unless the context clearly indicates otherwise, terms like 'connect' and 'couple' do not necessarily mean direct and/or fixed connection or coupling of two members and do not exclude another member interposed between two members.

The terms mean that features or elements described in the specification are present and does not exclude the possibility that one or more other features or elements may be added.

Sizes of elements in the drawings may be exaggerated for convenience of explanation. In other words, since sizes and thicknesses of components in the drawings are arbitrarily illustrated for convenience of explanation, the following embodiments are not limited thereto.

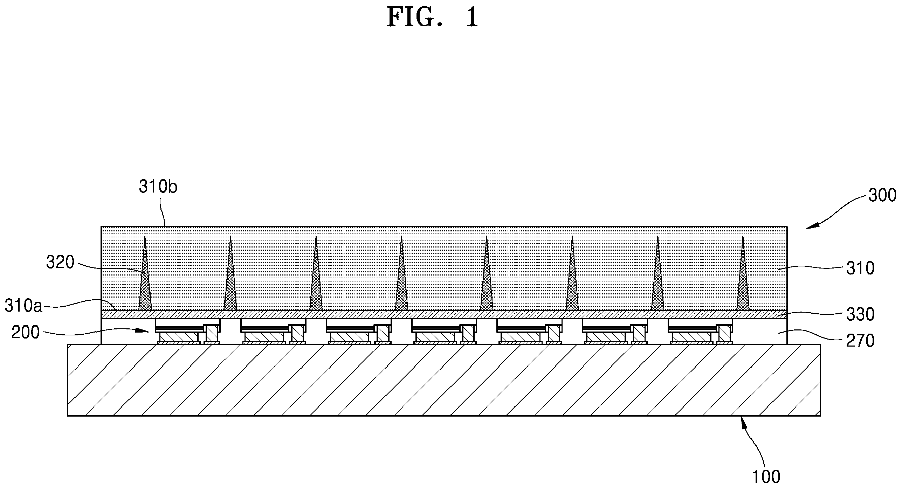

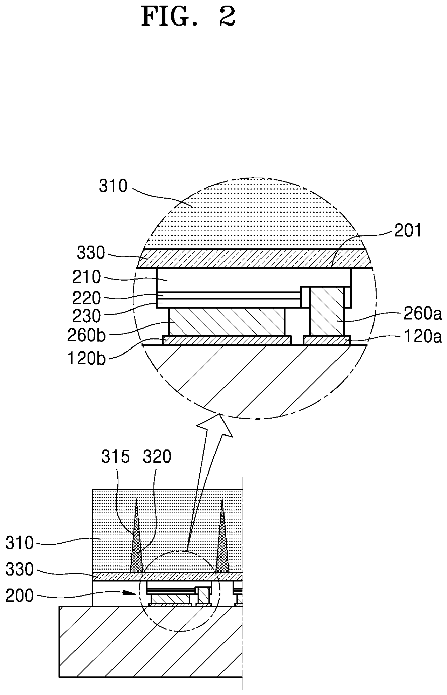

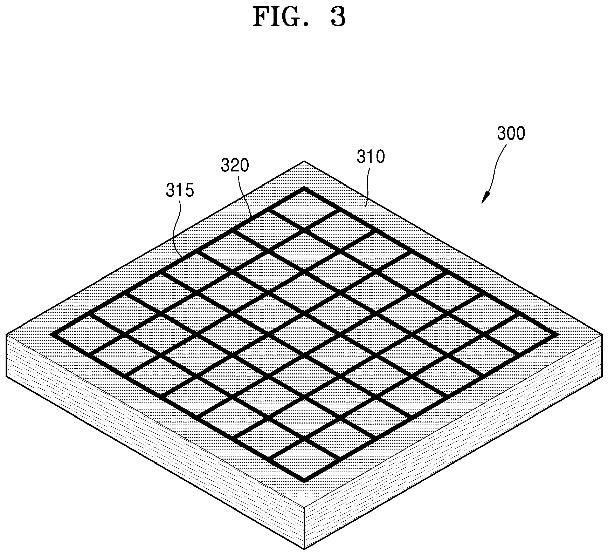

FIG. 1 is a cross-sectional view of a micro LED panel according to an embodiment of the disclosure, FIG. 2 is an enlarged cross-sectional view of a portion of FIG. 1, and FIG. 3 is a perspective view of a partitioning wall structure applicable to the micro LED panel shown in FIG. 1.

Referring to FIGS. 1 to 3, the micro LED panel according to an embodiment of the disclosure includes a backplane 100, a plurality of micro LED cells 200, a partitioning wall structure 300, and an adhesive member 330.

On the backplane 100, a plurality of individually-driven LED driving circuits may be arranged in a matrix shape. The plurality of LED driving circuits may include a plurality of pairs of electrode units including a first electrode unit 120a and a second electrode unit 120b. Also, although not shown, a driving IC for controlling the operation of the plurality of micro LED cells 200 may be provided on the backplane 100.

The plurality of micro LED cells 200 may be arranged in a matrix shape on the backplane 100, wherein the plurality of micro LED cells 200 may be arranged at positions respectively corresponding to the plurality of LED driving circuits of the backplane 100. Each of the plurality of micro LED cells 200 is configured to include both a first conductive type electrode pad 260a, which is bonded to the first electrode unit 120a of the backplane 100, and a second conductivity type electrode pad 260b, which is bonded to the second electrode unit 120b, on the bottom surface, and a light-emitting surface may be formed on the top surface of each of the plurality of micro LED cells 200.

Also, the plurality of micro LED cells 200 may be formed through cell separation of a gallium nitride-based semiconductor stack grown on a sapphire substrate, which is a growth substrate. A manufacturing method for separating a gallium nitride-based semiconductor stack will be described later in detail.

Each of the plurality of micro LED cells 200 sequentially includes a first conductivity type semiconductor layer 210, an active layer 220, and a second conductivity type semiconductor layer 230 that are sequentially arranged in a direction away from a light-emitting surface 201. At this time, portions of the second conductivity type semiconductor layer 230 and the active layer 220 are selectively removed, and thus a portion of the first conductivity type semiconductor layer 210 is exposed toward the backplane 100, the first conductive type electrode pad 260a is connected to the first conductivity type semiconductor layer 210 through the exposed portion. Also, the second conductivity type electrode pad 260b is connected to the second conductivity type semiconductor layer 230.

Although not shown, a reflective layer, and more preferably, distributed Bragg reflectors (DBR) may be formed to cover at least lower portions of the respective micro LED cells 200. As the sapphire substrate, which is the growth substrate, is removed, a distance from the active layer 220 and the reflective layer (not shown) to the light-emitting surface of the micro LED cell 200 is reduced, and thus the spreading of light of the micro LED cell 200 to another region may be minimized.

Meanwhile, the partitioning wall structure 300 may be positioned above the light-emitting surface 201 of the plurality of micro LED cells 200, and a plurality of first grooves 315 may be formed therein. In this case, the partitioning wall structure 300 includes a light-transmitting member 310 having a first surface 310a facing the light-emitting surface 201 and a second surface 310b facing the first surface 310a, and the plurality of first grooves 315 may be formed on the first surface 310a or the second surface 310b of the light-transmitting member 310.

The light-transmitting member 310 may include a transmitting material that transmits light emitted from the micro LED cells 200 therethrough. In an embodiment, the light-transmitting member 310 may include a glass material and may include a phosphor for individual wavelength conversion of light of each of the micro LED cells 200. For example, the light-transmitting member 310 may include phosphor in glass (PIG).

Here, PIG is a composition in which a fluorescent material is mixed and dispersed and molded and sintered. In the case of using the PIG, deterioration and discoloration are less as compared to a conventional method of mixing an epoxy resin with a fluorescent material and then molding the same. Therefore a high power and high-efficiency LED package may be manufactured, the LED package exhibits high reliability at high temperatures. Also, since a fluorescent material is uniformly mixed with the glass in the PIG, an LED package having light uniformity and high brightness may be implemented. Therefore, the PIG may be applied to headlights of automobiles, flash lights of mobile phones for IT, high-power LED packages, etc.

The light-transmitting member 310 may include, on any one of the first surface 310a and the second surface 310b, a plurality of first grooves 315 formed correspondingly among the plurality of micro LED cells 200. The length of the plurality of first grooves 315 may be extended in a direction from any one of the first surface 310a and the second surface 310b toward the other. Also, the plurality of first grooves 315 may be formed in a structure surrounding the plurality of micro LED cells 200 arranged in a matrix shape. In other words, as shown in FIG. 3, the plurality of first grooves 315 may form a grid structure like a checkerboard when viewed from above the first surface 310a or the second surface 310b.

The plurality of first grooves 315 may be filled with a composition, from which a partitioning wall 320 that separates respective emission paths of light emitted from the plurality of micro LED cells 200 may be formed in the light-transmitting member 310. The light-transmitting member 310 may individually perform wavelength conversion on light (more particularly, blue light) emitted from a corresponding micro LED cell 200 through the partitioning wall 320, thereby generating white light.

Here, the partitioning wall 320 may include a composition that reflects or absorbs light emitted from the micro LED cells 200. The base material of the composition may be an organic or inorganic resin material. For example, the composition may include an organic or inorganic resin material like silicone, epoxy, heat-resistant resin polyimide, phenol resin, melamine resin, unsaturated polyester resin, tritan.

Meanwhile, the composition may form black partitioning walls for absorbing light by using carbon or a carbon mixture or may form while partitioning walls for reflecting light by using titanium dioxide (TiO₂), barium sulfate (BaSO₄), etc. Also, the composition may further include boron nitride (BN), aluminum nitride (AIN), aluminum (Al), graphite (Graphite), etc. Therefore, the light-transmitting member 310 may improve heat dissipation performance.

In another embodiment, the partitioning wall structure 300 may further include a substrate member 301 disposed on the second surface 310b of the light-transmitting member 310. The substrate member 301 may not only perform a function of supporting the light-transmitting member 310, but also perform a protection function like increasing the scratch resistance of the light-transmitting member 310. The substrate member 301 may include glass or a polymer material like polyethylene terephthalate (PET).

The adhesive member 330 may be formed between the first surface 310a of the light-transmitting member 310 and the light-emitting surface 201 of the plurality of micro LED cells 200. The adhesive member 330 adheres the partitioning wall structure 300 and the plurality of micro LED cells 200 to each other. The adhesive member 330 may include a light-transmitting material through which light may be transmitted, e.g., a material like semi-cured silicone or epoxy.

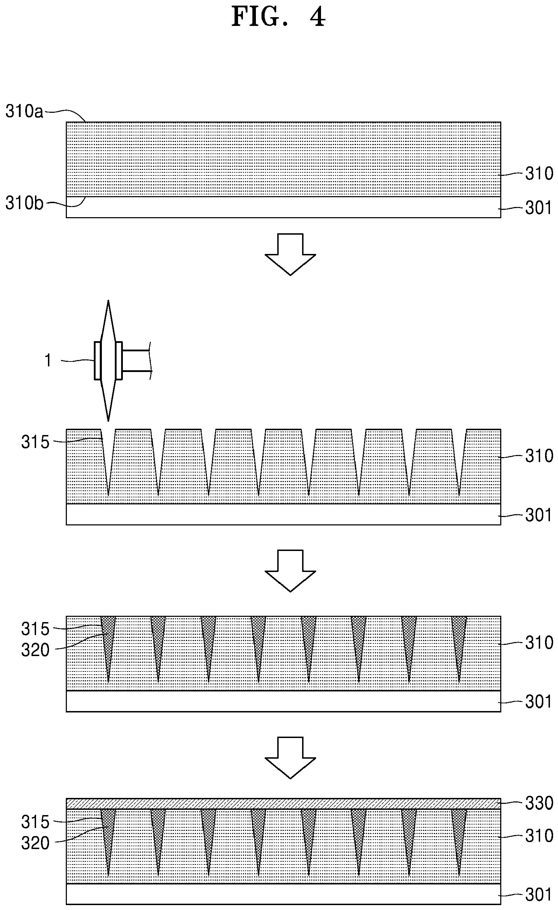

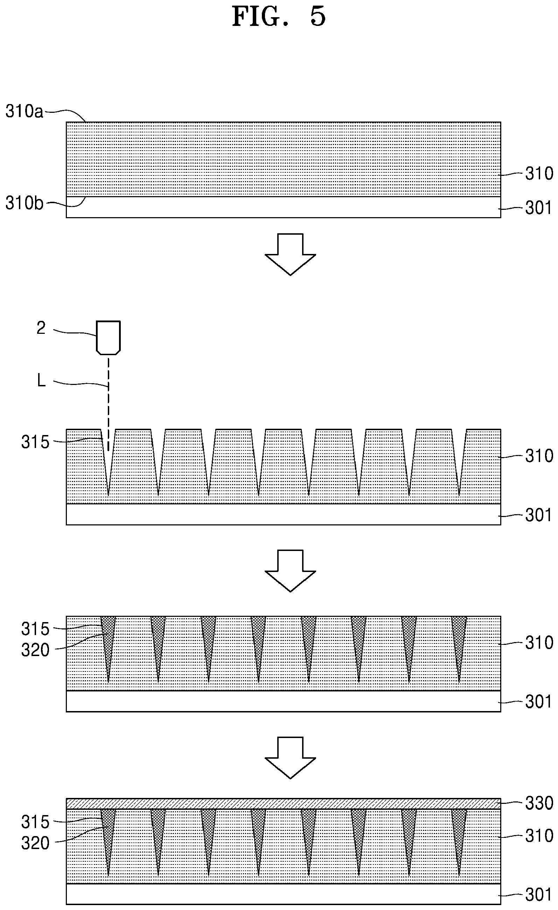

FIGS. 4 and 5 are diagrams for describing a method of manufacturing the partitioning wall structure stated above.

Referring to FIGS. 4 and 5, the method of manufacturing a partitioning wall structure according to an embodiment of the disclosure may include preparing the light-transmitting member 310, forming the plurality of first grooves 315 on the light-transmitting member 310, forming the partitioning wall 320 by filling the plurality of first grooves 315 with a composition, and disposing the adhesive member 330 on the first surface 310a of the light-transmitting member 310.

In an embodiment, the light-transmitting member 310 may be prepared on the substrate member 301. The light-transmitting member 310 is supported by the substrate member 301 and may be prepared in a state that the second surface 310b of the light-transmitting member 310 is contacting the substrate member 301. However, the technical spirit of the disclosure is not limited thereto. When a partitioning wall is formed on the second surface 310b, the substrate member 301 may be disposed on the second surface 310b of the light-transmitting member 310 after performing a process of forming the partitioning wall on the second surface 310b of the light-transmitting member 310, which is described later. Hereinafter, for convenience of explanation, descriptions below will focus on a method of forming the partitioning wall 320 on the first surface 310a of the light-transmitting member 310.

Thereafter, the plurality of first grooves 315 are formed on the light-transmitting member 310, wherein the plurality of first grooves 315 may be cut-formed from the first surface 310a facing the second surface 310b of the light-transmitting member 310 to a pre-set depth. Here, the plurality of first grooves 315 may be formed by using a contact or non-contact cutting device.

For example, as shown in FIG. 4, the plurality of first grooves 315 may be cut-formed to a pre-set depth from the first surface 310a by using a contact cutting device 1 like a cutting blade. Alternatively, as shown in FIG. 5, the plurality of first grooves 315 may be cut-formed to a pre-set depth from the first surface 310a by using a non-contact cutting device 2 like a laser source.

The plurality of first grooves 315 formed through the above-described process may have a shape in which the width becomes narrower in a depth-wise direction away from the first surface 310a.

Thereafter, the plurality of first grooves 315 are filled with a composition, and thus the partitioning wall 320 is formed. The base material of the composition includes an organic or inorganic resin material, and the composition thereof may vary depending on whether the partitioning wall 320 is a reflective partitioning wall or an absorbing partitioning wall.

Thereafter, the adhesive member 330 may be disposed on the first surface 310a of the light-transmitting member 310 and the partitioning wall structure 300 may be adhered to the plurality of micro LED cells 200 through the adhesive member 330.

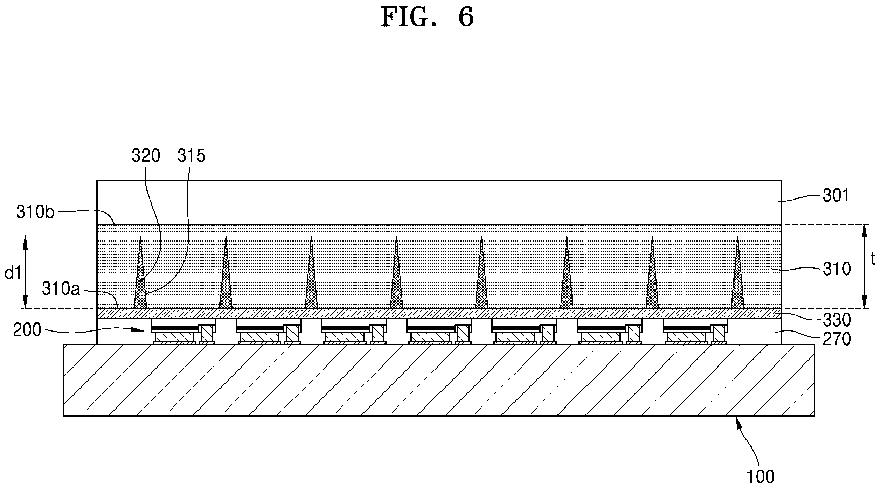

FIGS. 6 to 11 are diagrams showing examples of a partitioning wall structure according to various embodiments of the disclosure.

Referring to FIG. 6, the partitioning wall structure 300 may include the light-transmitting member 310 in which partitioning walls 320 are formed, the adhesive member 330 disposed between the first surface 310a of the light-transmitting member 310 and light-emitting surfaces of the plurality of micro LED cells 200, and the substrate member 301 disposed on the light-transmitting member 310.

The partitioning wall 320 may be formed by filling the plurality of first grooves 315 formed from the first surface 310a toward the second surface 310b of the light-transmitting member 310 with a composition. In this case, a depth d1 of the partitioning wall 320 may have a value between 1/2 times a thickness t of the light-transmitting member 310 and the thickness t. Also, the light-transmitting member 310 may include a phosphor for individual wavelength conversion of light of each of the micro LED cells 200.

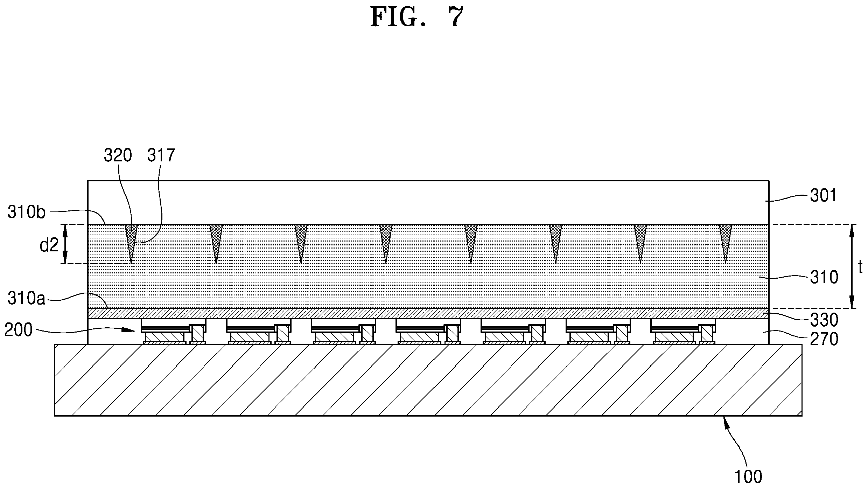

In another embodiment, referring to FIG. 7, the partitioning wall 320 may be formed by forming a plurality of second grooves 317 on the second surface 310b instead of the first surface 310a of the light-transmitting member 310 and filling the plurality of second grooves 317 with the composition. Here, a depth d2 of the plurality of second grooves 317 may be less than 1/2 times the thickness t of the light-transmitting member 310.

To form grooves on the second surface 310b of the light-transmitting member 310, it is necessary to perform a cutting process on the light-transmitting member 310 without the substrate member 301 serving as a support member. Therefore, the partitioning wall structure may be stably manufactured by forming the plurality of second grooves 317 in the light-transmitting member 310 to a depth smaller than 1/2 times the thickness t of the light-transmitting member 310.

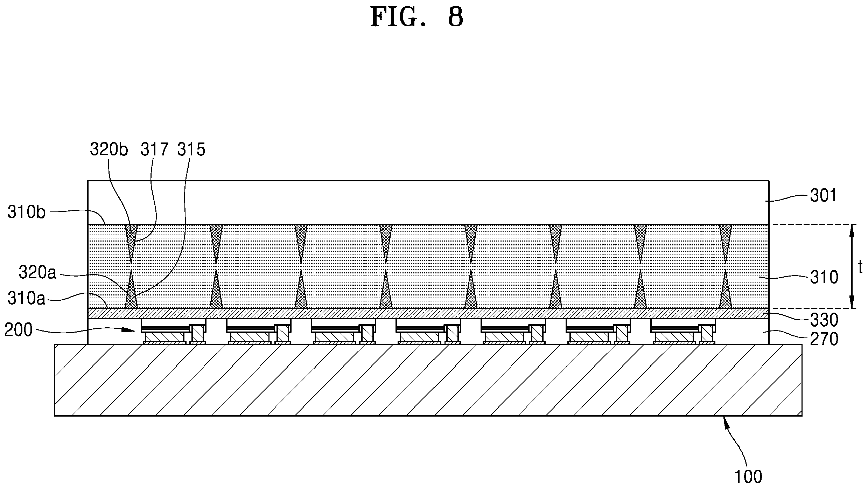

In another embodiment, referring to FIG. 8, the partitioning wall 320 may be formed by forming a plurality of grooves on both the first surface 310a and the second surface 310b of the light-transmitting member 310 and filling the plurality of grooves with a composition. In other words, the plurality of first grooves 315 may be formed on the first surface 310a of the light-transmitting member 310, and the plurality of second grooves 317 may be formed on the second surface 310b of the light-transmitting member 310. Here, the plurality of first grooves 315 and the plurality of second grooves 317 may be symmetrically formed to face each other, and the plurality of first grooves 315 and the plurality of second grooves 317 facing each other do not contact each other.

The partitioning wall structure of FIG. 8 may be manufactured by forming the plurality of second grooves 317 on the second surface 310b of the light-transmitting member 310 first and filling the plurality of second grooves 317 with a composition and then forming the plurality of first grooves 315 on the first surface 310a of the light-transmitting member 310 and filling the plurality of first grooves 315 with a composition.

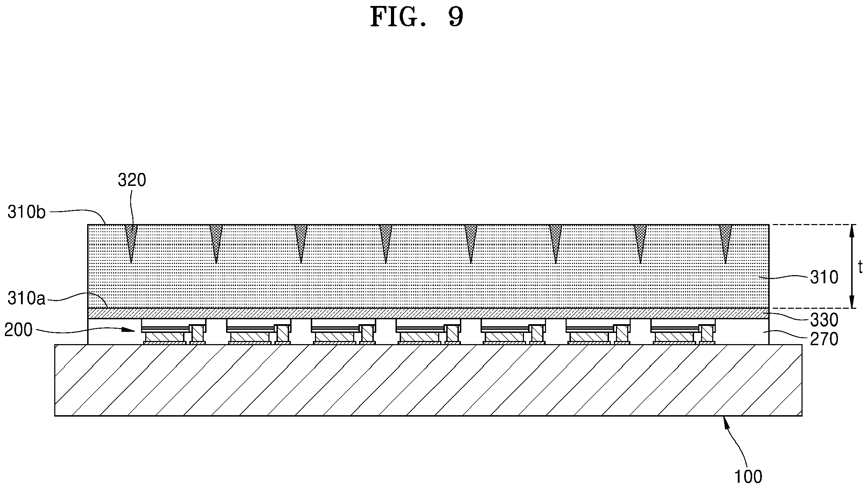

In another embodiment, referring to FIG. 9, after the partitioning wall structure is bonded to the plurality of micro LED cells 200, the substrate member 301 serving as the support member may be removed.

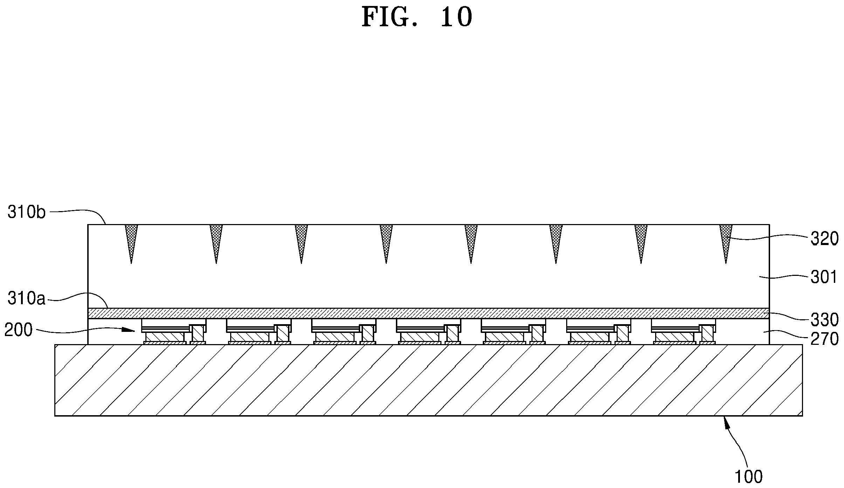

Alternatively, referring to FIG. 10, the partitioning wall structure may include only the substrate member 301 and the adhesive member 330 without a separate light-transmitting member including a phosphor. In this case, the partitioning wall 320 is formed by forming grooves in the substrate member 301 by using a contact or non-contact cutting device and filling the grooves with a composition, and a phosphor may be included in the adhesive member 330.

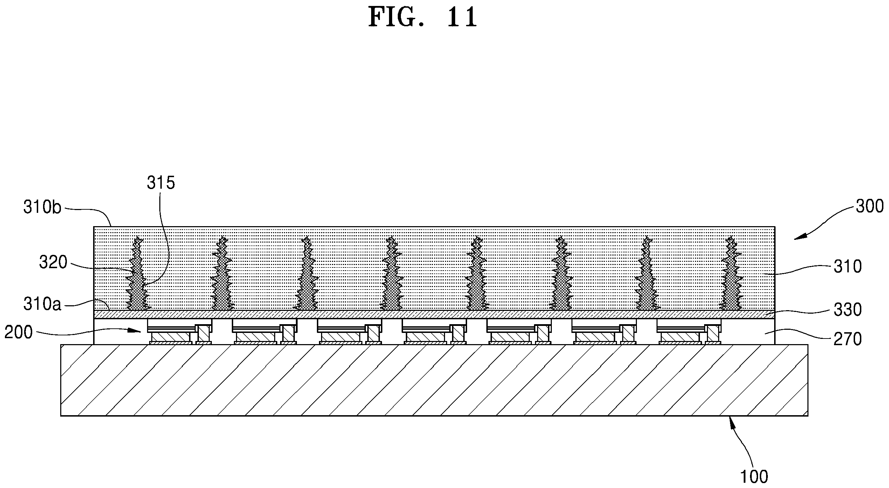

In another embodiment, referring to FIG. 11, the plurality of first grooves 315 may include concavo-convex surfaces. In detail, concaveness and convexness may be formed in the plurality of first grooves 315 or the plurality of second grooves 317 (refer to FIG. 7) formed in the light-transmitting member 310 along cut surfaces. Due to the first grooves 315 or the second grooves 317 having the above-described shape, the partitioning wall 320 may scatter light emitted from each of the micro LED cells 200 and improve light efficiency.

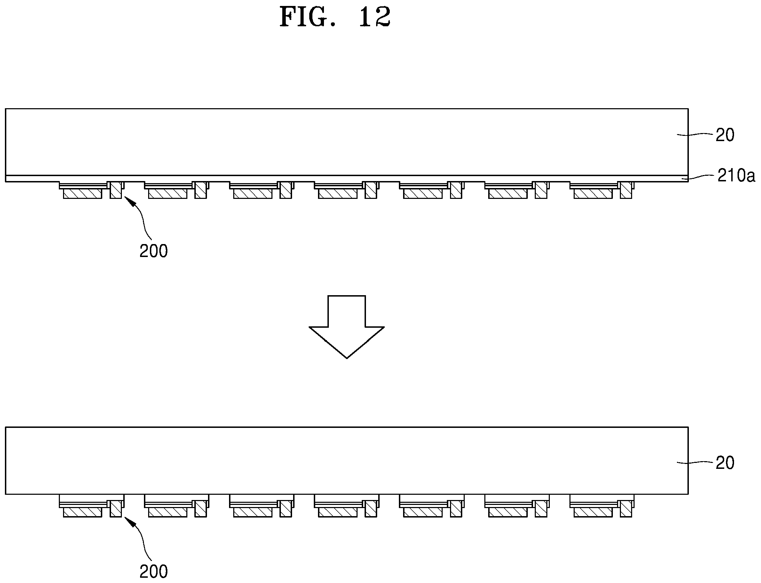

FIGS. 12 to 14 are diagrams for describing a method of manufacturing a micro LED panel according to an embodiment of the disclosure.

The method of manufacturing a micro LED panel according to the present embodiment includes preparing a backplane, forming micro LED cells in a matrix shape at the bottom of a growth substrate, bonding the micro LED cells to the backplane, separating the growth substrate from the micro LED cells, and disposing a partitioning wall structure on the micro LED cells. Here, since the method of manufacturing the partitioning wall structure has been described above with reference to FIGS. 4 and 5, descriptions identical to those given above will be omitted, and descriptions given below will focus on a process of forming micro LED cells and bonding the micro LED cells to a backplane with reference to FIGS. 12 to 14.

Referring to FIG. 12, in the micro LED cells 200, a gallium nitride-based semiconductor stack sequentially including the first conductivity type semiconductor layer 210, the active layer 220, and the second conductivity type semiconductor layer 230 is formed on a sapphire substrate serving as a growth substrate 20, and then, the gallium nitride-based semiconductor stack is divided into the plurality of micro LED cells 200 arranged in a matrix shape.

In detail, as a method of separating the micro LED cells 200, first, an active layer of micro LED cells may be separated by removing a portion of the second conductivity type semiconductor layer 210 and the active layer 220. Therefore, both the first conductivity type semiconductor layer 210 and the second conductivity type semiconductor layer 230 of each micro LED cell 200 may be exposed toward the backplane 100 therebelow. The first conductivity type electrode pad 260a and the second conductivity type electrode pad 260b are formed by, for example, depositing a metal material and are formed to be connected to the first conductivity type semiconductor layer 210 and the second conductivity type semiconductor layer 230, respectively.

In particular, according to the method of manufacturing a micro LED panel according to the present embodiment, the micro LED cells 200 may be separated from one another by removing a first conductivity type semiconductor layer 210a between the micro LED cells 200. Although FIG. 12 shows a state in which the first conductive type electrode pad 260a is connected to the first conductivity type semiconductor layer 210 and the second conductivity type electrode pad 260b is connected to the second conductivity type semiconductor layer 230 so as to illustrate the structure between the micro LED cells 200 and a method of removing the first conductivity type semiconductor layer 210a between the micro LED cells 200 is described above, the technical spirit of the disclosure is not limited thereto. In the method of manufacturing a micro LED panel according to the present embodiment, after portions of the second conductivity type semiconductor layer 230 and the active layer 220 are removed, the first conductivity type semiconductor layer 210 may be removed, and the first conductive type electrode pad 260a and the second conductivity type electrode pad 260b may be connected to exposed portions of the first conductivity type semiconductor layer 210 and the second conductivity type semiconductor layer 230, respectively.

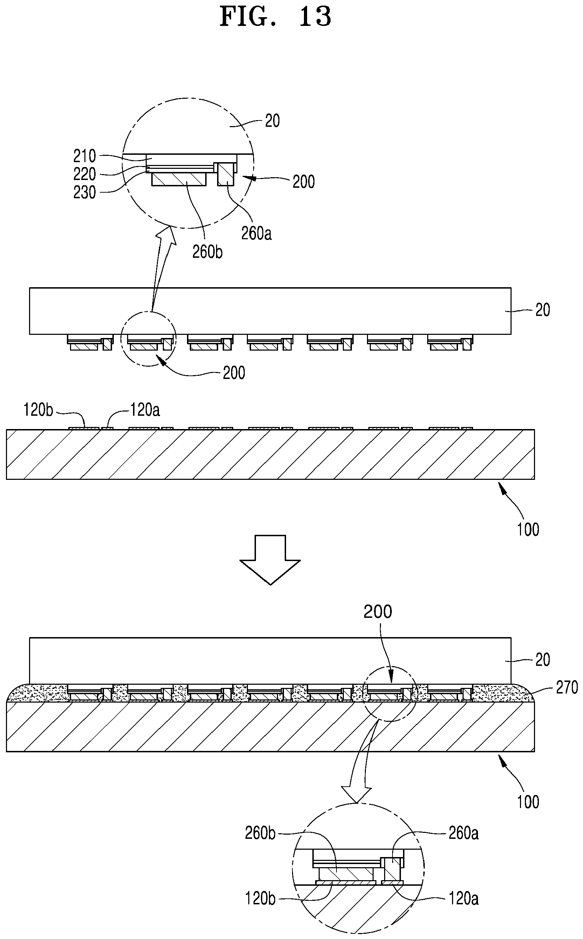

Referring to FIG. 13, the method of manufacturing a micro LED panel includes bonding the first conductive type electrode pad 260a and the second conductivity type electrode pad 260b of each of the micro LED cells 200 to the first electrode unit 120a and the second electrode unit 120b of the backplane 100, respectively. Through this operation, the plurality of micro LED cells 200 arranged on the bottom surface of the growth substrate 20 in a matrix shape are mounted on the backplane 100.

Also, the method of manufacturing a micro LED panel may further include filling an adhesive material between the micro LED cells 200 after the micro LED cells 200, which are arranged on the growth substrate 20 in a matrix shape, are mounted on the backplane 100 and curing the adhesive material. Since the first conductivity type semiconductor layer 210 is completely removed between the micro LED cells 200, the micro LED cells 200 may be separated into individual micro LED cells 200 by the adhesive material injected therebetween. Therefore, a micro LED panel manufactured according to the present embodiment may minimize the light spreading phenomenon that may occur in the first conductivity type semiconductor layer. The injected adhesive material is cured to form an adhesive layer 270 disposed on the growth substrate 20 and the backplane 100.

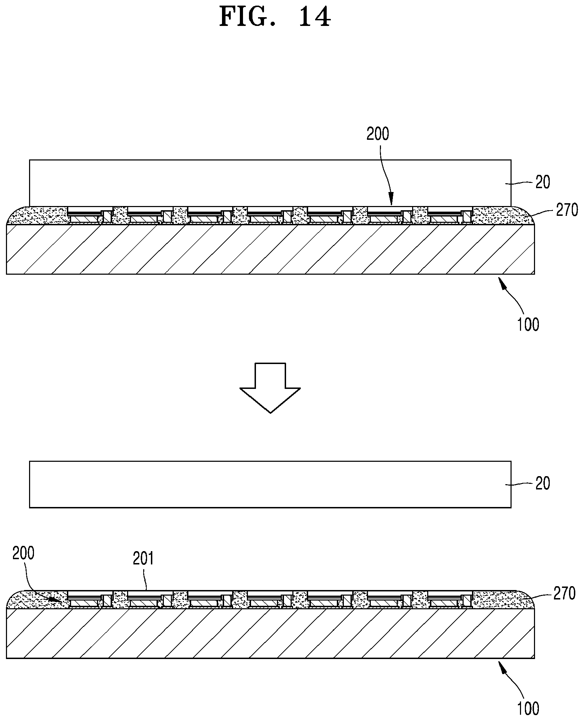

Referring to FIG. 14, the method of manufacturing a micro LED panel includes separating and removing the growth substrate 20 from the micro LED cells 200. A laser lift off (LLO) process may be applied to separate the growth substrate 20. When the growth substrate 20 is separated through the LLO process, since electrode pads respectively formed at the micro LED cells 200 are bonded to the electrode units of the backplane 100, displacement and undesired deformation of the micro LED cells 200 may be suppressed. In particular, in the method of manufacturing a micro LED panel according to the present embodiment, since the micro LED cells 200 are adhered to each other by using an adhesive material, defects due to separation of the growth substrate 20 may be suppressed.

In the micro LED cells 200, light-emitting surfaces 201 are exposed as the growth substrate 20 is removed. Thereafter, the method of manufacturing a micro LED panel includes disposing the partitioning wall structure 300 (refer to FIG. 1) over the micro LED cells 200 after the growth substrate 20 is removed. The partitioning wall structure 300 is closely attached to the top of the micro LED cells 200 through the adhesive member 330. Here, the partitioning wall structure 300 uses the light-transmitting member 310 in which the partitioning walls 320 are formed to perform individual wavelength conversion on light emitted from each of the micro LED cells 200, thereby generating white light.

As described above, according to a micro LED panel and a method of manufacturing a micro LED panel according to embodiments of the disclosure, partitioning walls are formed in a light-transmitting member including a phosphor without forming a separate partitioning wall structure, thereby simplifying the overall manufacturing process. Therefore, individual pixels may be implemented at inexpensive process costs.

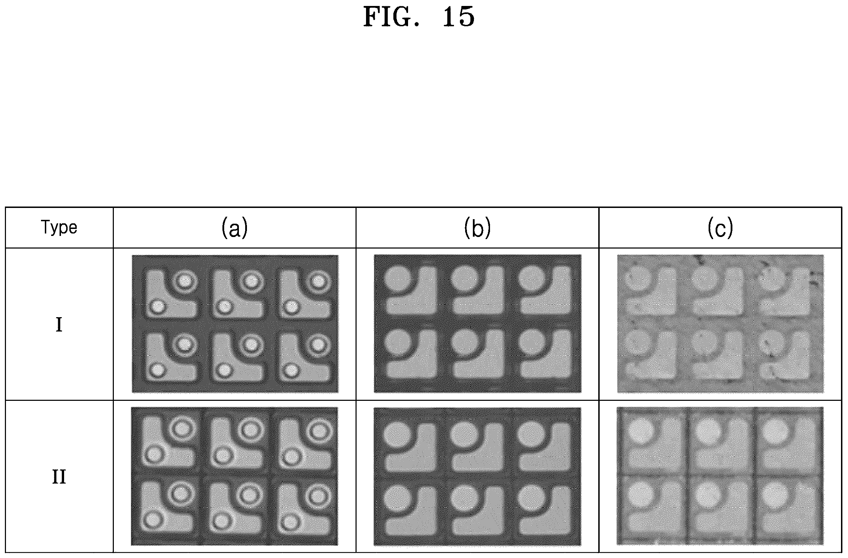

FIG. 15 is a diagram showing images of micro LED panels manufactured according to the present embodiment and a comparative example compared for each process. FIG. 15A is an image showing bottom surfaces of micro LED cells, FIG. 15B is an image showing top surfaces of micro LED cells before removal of a growth substrate, and FIG. 15C is an image showing top surfaces of micro LED cells after removal of the growth substrate.

Referring to FIG. 15, it may be seen that, in a micro LED panel (I) according to the comparative example, a plurality of micro LED cells are not completely separated from one another and a first conductivity type semiconductor layer remains therebetween. On the contrary, it may be seen that, in a micro LED panel II according to the present embodiment, a first conductivity type semiconductor layer is removed between a plurality of micro LED cells, and thus clear dividing lines are formed therebetween. Due to the difference, according to a micro LED panel and a method of manufacturing a micro LED panel according to embodiments of the disclosure, light spreading phenomenon due to a first conductivity type semiconductor layer may be minimized by completely removing the first conductivity type semiconductor layer between micro LED cells.

According to a micro LED panel and a method of manufacturing a micro LED panel according to embodiments of the disclosure, partitioning walls are formed in a light-transmitting member including a phosphor without forming a separate partitioning wall structure, thereby simplifying the overall manufacturing process. Therefore, individual pixels may be implemented at inexpensive process costs.

According to a micro LED panel and a method of manufacturing a micro LED panel according to embodiments of the disclosure, light spreading phenomenon due to a first conductivity type semiconductor layer may be minimized by completely removing the first conductivity type semiconductor layer between micro LED cells.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the spirit and scope as defined by the following claims.

## Claims

1. A method of manufacturing a micro LED panel, the method comprising:
preparing a backplane;
forming a plurality of micro LED cells in a matrix shape on a bottom portion of a growth substrate;
bonding the micro LED cells to the backplane;
separating the growth substrate from the micro LED cells; and
disposing a partitioning wall structure on top portions of the micro LED cells,
wherein the partitioning wall structure comprises a light-transmitting member having a first surface facing light-emitting surfaces of the micro LED cells and a second surface facing the first surface,
the light-transmitting member comprises a plurality of first grooves formed to correspond in between the plurality of micro LED cells on any one of the first surface and the second surface, and
the plurality of first grooves are filled with a partitioning wall composition to form partitioning walls.

2. The method of claim 1, wherein the partitioning wall structure is formed through a process comprising:
preparing the light-transmitting member;
forming the plurality of first grooves by cutting to a pre-set depth from the first surface or the second surface of the light-transmitting member by using a contact or non-contact cutting device; and
forming partitioning walls by filling the plurality of first grooves with a partitioning wall composition.

3. The method of claim 1 or 2, wherein the light-transmitting member comprises a phosphor for individual wavelength conversion of light from each of the micro LED cells.

4. The method of any one of the preceding claims, wherein the light-transmitting member further comprises a plurality of second grooves formed on the other one of the first surface and the second surface to face the plurality of first grooves.

5. The method of any one of the preceding claims, wherein the plurality of first grooves comprises concave-convex surfaces.

6. The method of any one of the preceding claims, wherein the forming of the plurality of micro LED cells in a matrix shape at the bottom of the growth substrate comprises:
sequentially stacking a first conductivity type semiconductor layer, an active layer, and a second conductivity type semiconductor layer on the growth substrate;
separating active layers of the micro LED cells by removing portions of the second conductivity type semiconductor layer and the active layer; and
separating the micro LED cells by removing the first conductivity type semiconductor layer between the micro LED cells.

7. The method of any one of the preceding claims, further comprising,
after the bonding of the micro LED cells to the backplane and before the separating of the growth substrate from the micro LED cells,
filling and curing an adhesive material between the micro LED cells.

8. A micro LED panel comprising:
a backplane on which a plurality of individually driven LED driving circuits are arranged in a matrix shape;
a plurality of micro LED cells formed to respectively correspond to the plurality of LED driving circuits and each having a pair of first conductivity type electrode pad and a second conductivity type electrode pad formed therebelow;
a partitioning wall structure located above the light-emitting surfaces of the micro LED cells and having a plurality of first grooves formed therein; and,
an adhesive member formed between a top portion of the light-emitting surfaces and a bottom portion of the partitioning wall structure,
wherein the plurality of first grooves are formed at locations corresponding to in between the micro LED cells, and,
in the partitioning wall structure, partitioning walls are formed by filling the plurality of first grooves with a composition.

9. The micro LED panel of claim 8, wherein
the partitioning wall structure comprises a light-transmitting member having a first surface facing the light-emitting surfaces and a second surface facing the first surface, and
the plurality of first grooves are formed on any one of the first surface and the second surface of the light-transmitting member.

10. The micro LED panel of claim 8 or 9, wherein the light-transmitting member comprises a phosphor for individual wavelength conversion of light from each of the micro LED cells.

11. The micro LED panel of any one of claims 8 to 10, wherein the adhesive member comprises a phosphor for individual wavelength conversion of light from each of the micro LED cells.

12. The micro LED panel of claim 9, wherein the light-transmitting member further comprises a plurality of second grooves formed on the other one of the first surface and the second surface to face the plurality of first grooves.

13. The micro LED panel of claim 12, wherein the plurality of first grooves and the plurality of second grooves facing each other do not contact each other.

14. The micro LED panel of any one of claims 9 to 13, wherein the plurality of first grooves are formed by cutting to a pre-set depth from the first surface or the second surface of the light-transmitting member by using a contact or non-contact cutting device.

15. The micro LED panel of claim 14, wherein a first depth of the plurality of first grooves is less than 1/2 times a thickness of the light-transmitting member.

16. The micro LED panel of claim 14, wherein the first depth of the plurality of first grooves has a value between 1/2 and 1 times the thickness of the light-transmitting member.

17. The micro LED panel of any one of claims 8 to 16, wherein the composition comprises an organic or inorganic resin material.

18. The micro LED panel of any one of claims 8 to 17, wherein the plurality of first grooves comprises concave-convex surfaces.

19. The micro LED panel of any one of claims 9 to 18, wherein a width of the plurality of first grooves becomes narrower in a depth-wise direction away from the first surface or the second surface on which the first grooves are formed.

20. The micro LED panel of any one of claims 9 to 19, wherein the partitioning wall structure further comprises a substrate member disposed on the second surface of the light-transmitting member.
